# EUROPÄISCHE PATENTSCHRIFT

(11) **EP 2 446 288 B1**
(45) Veröffentlichungstag und Bekanntmachung des Hinweises auf die Patenterteilung: **20.03.2013**
(21) Anmeldenummer: 09779969.6
(22) Anmeldetag: 26.06.2009
(51) Int. Cl.: G01R 33/07

(54) **HYBRID-SENSORANORDNUNG**
HYBRID SENSOR
CAPTEUR HYBRIDE

(43) Veröffentlichungstag der Anmeldung: 02.05.2012
(73) Patentinhaber: Continental Teves AG & Co. oHG, 60488 Frankfurt (DE)
(72) Erfinder: FRITZ, Wolgang, 35398 Giessen (DE); RINK, Klaus, 63517 Rodenbach (DE)
(86) Internationale Anmeldenummer: PCT/EP2009/058043
(87) Internationale Veröffentlichungsnummer: WO 2010/149218

(56) Entgegenhaltungen:
- WO-A2-2006/035055
- DE-A1- 19 722 016
- DE-A1-102004 015 205
- DE-T2- 69 000 943
- US-B1- 6 326 781

## Beschreibung

Die Erfindung betrifft eine Positions- und/oder Geschwindigkeitssensoranordnung gemäß Oberbegriff von Anspruch 1, ein Verfahren zur Positions- und/oder Geschwindigkeitsmessung gemäß Oberbegriff von Anspruch 11 sowie die Verwendung der Sensoranordnung in Kraftfahrzeugen.

Druckschrift DE 10 2005 039 280 A1 schlägt einen integrierten Sensor vor, der eine Gruppe von Magnetfeldsensorelementen und eine Signalverarbeitungsschaltung aufweist. Die Gruppe umfasst dabei Magnetfeldsensorelemente mit unterschiedlichen Haupterfassungsrichtungen, beispielsweise sowohl magnetoresistive Sensorelemente als auch Hallelemente. Die Magnetfeldsensorelemente der Gruppe sind dabei in Form eines Gitters angeordnet und erfassen ein Magnetfeld ortsaufgelöst, also bezüglich verschiedener Erfassungspunkte. DE 102004015205, DE 19722016 und DE 69000943 offenbaren auch Sensoren mit verschiedenen Magnetfeldsensorelementen.

Die Erfindung hat sich die Aufgabe gestellt, eine Positions- und/oder Geschwindigkeitssensoranordnung und ein Verfahren zur Positions- und/oder Geschwindigkeitsmessung vorzuschlagen, welche/s lediglich eine relativ einfache Signalverarbeitung zur Gewinnung von Positions- und/oder Geschwindigkeitsinformationen und insbesondere Zusatzinformationen benötigt.

Die Aufgabe wird erfindungsgemäß gelöst durch die Sensoranordnung gemäß Anspruch 1 und das Verfahren gemäß Anspruch 11.

Der Erfindung liegt der Gedanke zu Grunde, wenigstens zwei Magnetfeldsensorelemente mit zueinander unterschiedlicher Haupterfassungsrichtung so anzuordnen, dass die Elementausgangssignale dieser Magnetfeldsensorelemente einen Phasenverschiebungsbetrag zwischen 75° und 105° zueinander aufweisen.

Unter einer ersten sensitiven Hauptebene wird vorzugsweise eine Ebene verstanden, bezüglich welcher der Sensor sensitiv ist und Feldkomponenten des Magnetfelds erfassen kann, welche diese Ebene durchdringen. Die Durchdringungswinkel der Feldkomponenten, die erfasst werden können sind dabei insbesondere von der Art und der Anordnung der Magnetfeldsensorelemente abhängig.

Die Encoderspurfläche weist bevorzugt einen Maßstab zur Codierung bzw. Erfassung rotatorischer oder alternativ translatorischer Relativbewegungen auf.

Das Magnetfeld wird vorzugsweise im Zuge einer Relativbewegung zwischen Encoder und Sensor durch den Encoder moduliert. Dabei ist insbesondere der Sensor oder der Encoder ortsfest angeordnet.

Die Sensoranordnung ist bevorzugt über zumindest zwei Leitungen mit einer elektronischen Kontrolleinheit verbunden und wird insbesondere über diese beiden Leitungen mit Energie versorgt. Der Sensor ist dem entsprechend zweckmäßigerweise als aktiver Sensor ausgebildet.

Die erste Haupterfassungsrichtung des ersten Magnetfeldsensorelements liegt vorzugsweise in der ersten sensitiven Hauptebene des Sensors.

Die erste sensitive Hauptebene des Sensors ist bevorzugt eine Basisfläche eines Sensorgehäuses bzw. zu dieser Basisfläche im Wesentlichen parallel.

Der Phasenverschiebungsbetrag zwischen dem mindestens einen Elementausgangssignal des ersten Magnetfeldsensorelements und dem wenigstens einen Elementausgangssignal des zweiten Magnetfeldsensorelements beträgt zweckmäßigerweise im Wesentlichen 90°.

Es ist bevorzugt, dass das erste und das zweite Magnetfeldsensorelement so ausgebildet sind, dass das erste Magnetfeldsensorelement im Wesentlichen Magnetfeldkomponenten in anderer Richtung erfasst als das zweite Magnetfeldsensorelement. Dies resultiert insbesondere aus der ersten und zweiten Haupterfassungsrichtung, welche dem jeweiligen Magnetfeldsensorelementtyp zugeordnet ist.

Der Sensor ist vorzugsweise bezüglich seiner ersten sensitiven Hauptebene im Wesentlichen parallel zur Encoderspurfläche des Encoders ausgerichtet. Alternativ vorzugsweise sind Sensor und Encoder relativ so zueinander ausgerichtet angeordnet, dass der Winkel zwischen der ersten sensitiven Hauptebene des Sensors und der Encoderspurfläche weniger als 15° beträgt. Durch diese Anordnung kann die Sensoranordnung relativ flach bzw. platzsparend und dadurch relativ kostengünstig ausgebildet werden.

Das erste und das zweite Magnetfeldsensorelement weisen jeweils bevorzugt eine oder mehrere sensitive Strukturen auf, die jeweils im Wesentlichen in einer Strukturebene angeordnet sind, wobei das erste und das zweite Magnetfeldsensorelement bezüglich ihrer jeweiligen Strukturebene im Wesentlichen zueinander parallel oder in einer gemeinsamen Ebene angeordnet sind. Alternativ vorzugsweise beträgt der Winkel zwischen den Strukturebenen des ersten und des zweiten Magnetfeldsensorelements weniger als 15°. Unter einer sensitiven Struktur wird dabei besonders bevorzugt ein Leitersegment eines magnetoresistiven Sensorelements und/oder eine Hallzelle bzw. ein Segment eines Hall-Elements verstanden.

Die erste Haupterfassungsrichtung ist zweckmäßigerweise gegenüber der zweiten Haupterfassungsrichtung um im Wesentlichen 90° gedreht ausgeprägt.

Das erste Magnetfeldsensorelement mit der ersten Haupterfassungsrichtung ist bevorzugt als magnetoresistives Sensorelement ausgebildet und das zweite Magnetfeldsensorelement mit der zweiten Haupterfassungsrichtung als Hall-Element. Das wenigstens eine magnetoresistive Sensorelement ist insbesondere als AMR- (anisotrop magnetoresistive) oder GMR- (giant magnetoresistive) Sensorelement oder als ein anderes magnetoresistives Sensorelement ausgebildet.

Die Encoderspurfläche des Encoders ist vorzugsweise alternierend codiert und weist insbesondere mehrere Nord-Südpolpaare und/oder Zahn-Lückenpaare auf.

Zumindest das erste und das zweite Magnetfeldsensorelement sind zweckmäßigerweise so angeordnet, dass sie das Magnetfeld bezüglich der ersten sensitiven Hauptebene des Sensors in einem definierten, gemeinsamen Erfassungspunkt im Wesentlichen gemeinsam erfassen. Dabei sind insbesondere ein oder mehrere Magnetfeldsensorelemente mit der ersten Haupterfassungsrichtung gemeinsam relativ gegenüber einem oder mehreren Magnetfeldsensorelementen mit der zweiten Haupterfassungsrichtung bezüglich der sensitiven Hauptebene und des definierten Erfassungspunktes im Wesentlichen konzentrisch angeordnet. Unter dem gemeinsamen Erfassungspunkt wird besonders bevorzugt ein gemeinsamer Lesepunkt des Sensors verstanden.

Der Sensor weist bevorzugt eine Signalverarbeitungsschaltung auf, die so ausgelegt ist, dass sie zumindest aus den Elementausgangssignalen des ersten und des zweiten Magnetfeldsensorelements ein, insbesondere digitales, Sensorausgangssignal erzeugt, welches zumindest eine der folgenden Informationen beinhaltet:
Die Relativ- und/oder Absolutposition zwischen Encoder und Sensor und/oder die Relativgeschwindigkeit zwischen Encoder und Sensor und/oder die relative Bewegungsrichtung zwischen Encoder und Sensor und/oder die magnetische Feldstärke des vom Sensor erfassten Magnetfeldes und/oder der Abstand zwischen Encoder und Sensor und/oder mindestens eine Information über die Plausibilität des Sensorausgangssignals.

Der Sensor umfasst zweckmäßigerweise einen Chip, welcher zumindest das erste und das zweite Magnetfeldsensorelement sowie insbesondere die Signalverarbeitungsschaltung aufweist. Der Chip ist besonders bevorzugt als ASIC ausgebildet, und umfasst ganz besonders bevorzugt wenigstens ein integriertes Hallelement sowie ein magnetoresistives Sensorelement, welches beispielsweise auf einer Außenfläche des Chips auf einer zusätzlichen Isolierschicht in Dünnschichttechnik aufgebracht ist.

Das erste und das zweite Magnetfeldsensorelement sind alternativ vorzugsweise mittels Drahtbond oder Flipchip direkt oder indirekt miteinander verbunden.

Es ist bevorzugt, dass der Sensor wenigstens ein magnetisches Mittel, insbesondere einen Permanentmagneten aufweist. Dieser ist besonders bevorzugt so magnetisiert, dass er ein magnetisches Stützfeld für mindestens ein als anisotrop magnetoresistives Sensorelement ausgebildetes Magnetfeldsensorelement bereitstellt und/oder ein Magnetfeld erzeugt welches durch einen Encoder, der im Wesentlichen kein eigenes Magnetfeld erzeugt, moduliert wird, wobei der Encoder hierfür zumindest teilweise aus weichmagnetischem Material ausgebildet ist.

Es ist zweckmäßig, dass das erste Magnetfeldsensorelement als AMR-Sensorelement (anisotrop magnetoresistiv) und das zweite Magnetfeldsensorelement als Hall-Element ausgebildet ist. Mittels des AMR-Elements wird aufgrund seiner relativ hohen Messempfindlichkeit eine relativ präzise Erfassung wenigstens einer Maßstabsteilung des Encoders und/oder eines definierten Maßstabsteilungssegments durchgeführt. Mittels des zusätzlichen Hall-Elements werden besonders bevorzugt Zusatzinformationen ermittelt bzw. berechnet.

Das Verfahren wird bevorzugt weitergebildet, indem in einer Signalverarbeitungsschaltung aus den Elementausgangssignalen zumindest eine der folgenden Informationen direkt oder indirekt gewonnen wird:
Die Relativ- und/oder Absolutposition zwischen Encoder und Sensor und/oder die Relativgeschwindigkeit zwischen Encoder und Sensor und/oder die relative Bewegungsrichtung zwischen Encoder und Sensor und/oder die magnetische Feldstärke des vom Sensor erfassten Magnetfeldes und/oder der Abstand zwischen Encoder und Sensor und/oder mindestens eine Information über die Plausibilität des Sensorausgangssignals.

Insbesondere ist dabei das erste Magnetfeldsensorelement als magnetoresistives Sensorelement ausgebildet und das zweite Magnetfeldsensorelement als Hall-Element und die beiden Elementausgangssignale werden so erzeugt, dass diese relativ zueinander einen Phasenverschiebungsbetrag von im Wesentlichen 90° aufweisen.

Es ist bevorzugt, dass eine Information über die relative Bewegungsrichtung zwischen Encoder und Sensor ermittelt wird, indem bezüglich der Elementausgangssignale des mindestens ersten und zweiten Magnetfeldsensorelements die Steigung, insbesondere das Vorzeichen der Steigung, des ersten Elementausgangssignals in einem ersten Nulldurchgang mit einer Steigung, insbesondere dem Vorzeichen der Steigung, des zweiten Elementausgangssignals in einem dem ersten Nulldurchgang vorlaufenden oder nachfolgenden Nulldurchgang verglichen bzw. berücksichtigt wird. Alternativ vorzugsweise wird eine Information über die relative Bewegungsrichtung zwischen Encoder und Sensor ermittelt, indem bei einem Nulldurchgang eines Elementausgangssignals, das Vorzeichen des Werts eines Elementausgangssignals eines anderen Magnetfeldsensorelements bestimmt wird. Hierbei wird insbesondere mittels eines Komparators der Wert des Elementausgangssignals des anderen Magnetfeldsensorelements mit einer Mittelwertspannung der Elementausgangssignale verglichen. Alternativ vorzugsweise wird eine Information über die relative Bewegungsrichtung zwischen Sensor und Encoder durch Ermittlung einer relativen Positionsänderung und/oder einer Winkeländerung zwischen dem ersten Elementausgangssignal und dem zweiten Elementausgangssignal bestimmt, indem insbesondere der Winkel des ersten Elementausgangssignals zu einem ersten Zeitpunkt und der Winkel des zweiten Elementausgangssignals zu einem zweiten Zeitpunkt ermittelt und berücksichtigt werden, wobei dieser erste und zweite Zeitpunkt einen Zeitabstand zueinander aufweisen, der geringer ist als die halbe Periodendauer der Elementausgangssignale. Hierdurch muss zur Bestimmung der relativen Bewegungsrichtung kein Nulldurchgang eines der Elementausgangssignale berücksichtigt werden.

Die magnetische Feldstärke bzw. eine Information über die magnetische Feldstärke des vom Sensor erfassten Magnetfeldes wird vorzugsweise ermittelt, indem im Wesentlichen zum Zeitpunkt eines Nulldurchgangs eines Elementausgangssignals der Wert des Elementausgangssignals eines anderen Magnetfeldsensorelements berücksichtig wird. Insbesondere wird bei einem Nulldurchgang des Elementausgangssignals eines magnetoresistiven Sensorelements der Wert eines Elementausgangssignals eines Hallelements berücksichtigt, besonders bevorzugt direkt aus diesem Wert die Feldstärke und/oder die magnetische Flussdichte bestimmt. Durch die Phasenverschiebung der Elementausgangssignale zueinander können die Nulldurchgänge eines Elementausgangssignals im Wesentlichen als Indikator für das Vorliegen des maximalen Betrages des Elementausgangssignals des anderen Magnetfeldsensorelements verwendet bzw. als "Triggerpunkte" zur Ermittlung der Magnetfeldstärke verwendet werden. Aus der zumindest einen Information über die magnetische Feldstärke und/oder Flussdichte wird anschließend ganz besonders bevorzugt der Abstand bzw. die Luftspaltlänge zwischen Encoder und Sensor ermittelt. Alternativ vorzugsweise wird die magnetische Feldstärke des vom Sensor erfassten Magnetfelds berechnet, indem der Kreisradius der beiden, insbesondere als sinus- und cosinusförmig ausgebildeten, Elementausgangssignale bestimmt wird und besonders bevorzugt die Wurzel aus der Summe, des Sinusquadrats des Werts des ersten Elementausgangsignals und des Cosinusquadrats des Werts des zweiten Elementausgangssignals, jeweils zu einem definierten Zeitpunkt, berechnet wird.

Unter einem Nulldurchgang wird zweckmäßigerweise ein Unter- oder Überschreiten eines definierten Werts, insbesondere eines Mittelwerts, durch ein Elementausgangssignal verstanden.

Die relative Bewegungsrichtung zwischen Encoder und Sensor, die magnetische Feldstärke des vom Sensor erfassten Magnetfeldes, der Abstand zwischen Encoder und Sensor, und die mindestens eine Information über die Plausibilität des Sensorausgangssignals sind vorzugsweise Zusatzinformationen.

Es ist zweckmäßig, dass in einer Signalverarbeitungsschaltung des Sensors und/oder in einer mit dem Sensor verbundenen elektronischen Kontrolleinheit eine Positionsinformation und/oder Geschwindigkeitsinformation durch Interpolation ermittelt wird. Dabei wird insbesondere das Elementausgangssignal eines Hall-Elements zur Korrektur bzw. Interpolation eines Elementausgangssignals eines AMR-Sensorelements verwendet.

Bevorzugt wird die magnetische Feldstärke aus dem Elementausgangssignal eines Hall-Elements bestimmt und bei der Auswertung des Elementausgangssignals eines AMR-Sensorelements zur Korrektur berücksichtigt, insbesondere hinsichtlich der Signalform des AMR-Elementausgangssignals, welches besonders bevorzugt in Abhängigkeit der magnetischen Feldstärke Oberwellen aufweist.

Zu Ermittlung bzw. Berechnung der relativen Position und/oder Geschwindigkeit zwischen Sensor und Encoder wird bevorzugt eine Arcustangesfunktion auf den Quotienten der Werte der Elementausgangssignale des ersten und des zweiten Magnetfeldsensorelements, zweckmäßigerweise zu einem gemeinsamen Zeitpunkt, angewendet, wobei diese Elementausgangssignale insbesondere als im Wesentlichen sinus- bzw. cosinusförmige Signale ausgebildet sind, welche um, im Wesentlichen, 90° zueinander phasenverschoben sind. Dieser Quotient, auf welchen die Arcustangensfunktion zur Bestimmung einer Positions- und/oder Geschwindigkeitsinformation angewendet wird, ist besonders bevorzugt für die jeweiligen Wertepaare der Elementausgangssignale des ersten und zweiten Magnetfeldsensorelements in einer Speichereinheit, ganz besonders bevorzugt als experimentell und/oder per Simulation ermittelte Wertetabelle bzw. als "look-up-table", hinterlegt. Auf diese Speichereinheit wird zweckmäßigerweise bei der Anwendung der Arcustangensfunktion zugegriffen. Durch die Speicherung von Werten in einer Wertetabelle und deren Verwendung bei Anwendung der Arcustangensfunktion können systematische Fehler, insbesondere betreffend die Signalform der Elementausgangssignale relativ leicht und präzise korrigiert werden bzw. daraus resultierende Fehler vermieden werden.

Das Elementausgangssignal eines Hall-Elements wird vorzugsweise zur "Flipp-Erkennung" des Elementausgangssignals eines AMR-Sensorelements verwendet. Unter "Flippen" wird dabei eine Signalstörung verstanden, welche sich in einer unerwünschten Verdopplung der Signalfrequenz des Elementausgangssignals des AMR-Sensorelements äußert und beispielsweise aus einer fehlerhaften Relativpositionierung zwischen Sensor und Encoder resultiert.

Der Sensor umfasst zweckmäßigerweise zumindest ein AMR-Sensorelement und ist relativ zum Encoder so angeordnet, dass das AMR-Sensorelement im Schwachfeldbetrieb bzw. als Feldsonde betrieben wird.

Unter der magnetischen Feldstärke des Magnetfeldes, die gemessen und/oder ermittelt wird, wird ebenso oder alternativ die magnetische Flussdichte oder eine andere Feldgröße verstanden.

Die Sensoranordnung ist zweckmäßigerweise nicht als Materialprüfungssonde ausgebildet, insbesondere nicht als Sonde zur Erfassung von Verunreinigungen in elektrisch leitendem Material bzw. in elektrisch leitenden Proben.

Der Sensor ist bevorzugt als Drehzahlsensor, insbesondere als Raddrehzahlsensor, ausgebildet.

Die erfindungsgemäße Sensoranordnung und das erfindungsgemäße Verfahren sind zur Verwendung in allen technischen Bereichen vorgesehen, in denen eine rotatorische oder translatorische Relativbewegung und/oder eine relative Position zwischen Encoder und Sensor erfasst werden soll. Bevorzugt sind die erfindungsgemäße Sensoranordnung und das erfindungsgemäße Verfahren zur Verwendung in Kraftfahrzeugen oder in der Automatisierungstechnik vorgesehen. Insbesondere ist die Verwendung in sicherheitskritischen Applikationen vorgesehen, besonders bevorzugt in Kraftfahrzeugbrems- und/oder regelungssystemen.

Weitere bevorzugte Ausführungsformen ergeben sich aus den Unteransprüchen und den nachfolgenden Beschreibungen von Ausführungsbeispielen an Hand von Figuren.

Es zeigen in schematischer Darstellung
- Fig. 1: ein Ausführungsbeispiel einer Sensoranordnung, bei welcher der Sensor bezüglich seiner ersten sensitiven Hauptebene parallel zur Encoderspurfläche des Encoders angeordnet ist,
- Fig. 2: eine beispielhafte Sensoranordnung, bei welcher der Sensor bezüglich seiner ersten sensitiven Hauptebene senkrecht zur Encoderspurfläche des Encoders angeordnet ist,
- Fig. 3: beispielhafte Signalverläufe der Elementausgangssignale des ersten und zweiten Magnetfeldsensorelements,
- Fig. 4: Ausführungsbeispiele für die relative Anordnung von einem oder mehreren Magnetfeldsensorelementen mit erster Haupterfassungsrichtung zu einem oder mehreren Magnetfeldsensorelementen mit zweiter Haupterfassungsrichtung,
- Fig. 5: ein Ausführungsbeispiel, bei welchem der Sensor mit einer elektronischen Kontrolleinheit verbunden ist, und
- Fig. 6: ein beispielhafter Sensor, welcher als integrierter Chip ausgebildet ist.

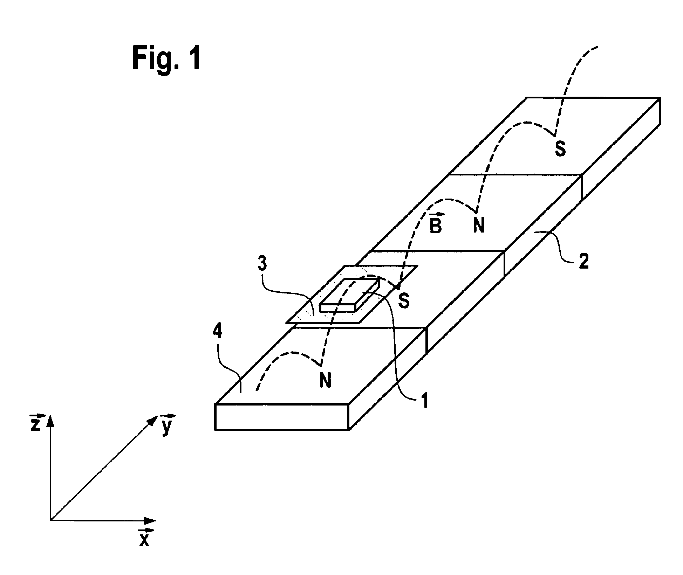

In Fig. 1 ist ein Ausführungsbeispiel einer Sensoranordnung dargestellt, bei welchem Sensor 1 bezüglich seiner ersten sensitiven Hauptebene 3 parallel gegenüber Encoderspurfläche 4 des Encoders 2 angeordnet ist. Encoder 2 ist alternierend codiert und weist Nord-Südpolpaare N, S auf, zwischen denen sich das Magnetfeld B, von dem lediglich eine Feldlinie stellvertretend veranschaulicht ist, ausprägt. Sensor 1 umfasst zwei nicht dargestellte Magnetfeldsensorelemente, von denen eines als AMR-Sensorelement ausgebildet ist und eine erste Haupterfassungsrichtung in Richtung der y-Achse des dargestellten kartesischen Koordinatensystems bzw. parallel zu dieser y-Achse aufweist. Das zweite Magnetfeldsensorelement ist als Hallelement ausgebildet und weist eine zweite Haupterfassungsrichtung in Richtung bzw. parallel zur z-Achse auf. Diese beiden Magnetfeldsensorelemente erfassen das durch den Encoder 2 erzeugte und im Zuge von Relativbewegungen zwischen Encoder 2 und Sensor 1 vom Encoder 2 modulierte Magnetfeld in einem gemeinsamen Erfassungs- bzw. Lesepunkt. Hierdurch und aufgrund der für die Magnetfeldsensorelemente verwendeten Elementtechnologien "AMR" und "Hall" weisen die Elementausgangssignale dieser beiden Magnetfeldsensorelemente zueinander eine Phasenverschiebung von 90° auf. Der Sensor 1 kann dabei relativ kompakte Abmessungen aufweisen, da die Phasenverschiebung zwischen den Elementausgangssignalen nicht durch eine von einander distanzierte Anordnung der Magnetfeldsensorelemente in Relativbewegungsrichtung, parallel zur y-Achse, zwischen Sensor 1 und Encoder 2, erzeugt wird. Das AMR-Sensorelement ist bezüglich seiner nicht dargestellten sensitiven Strukturen in der sensitiven Hauptebene angeordnet bzw. parallel zur Encoderspurfläche 4 angeordnet. Das AMR-Sensorelement wird somit im Schwachfeldbetrieb betrieben. Durch diese parallele Ausrichtung zwischen Sensor 1 und Encoder 2 wird eine relativ flache und platzsparende Ausbildung der Sensoranordnung erreicht.

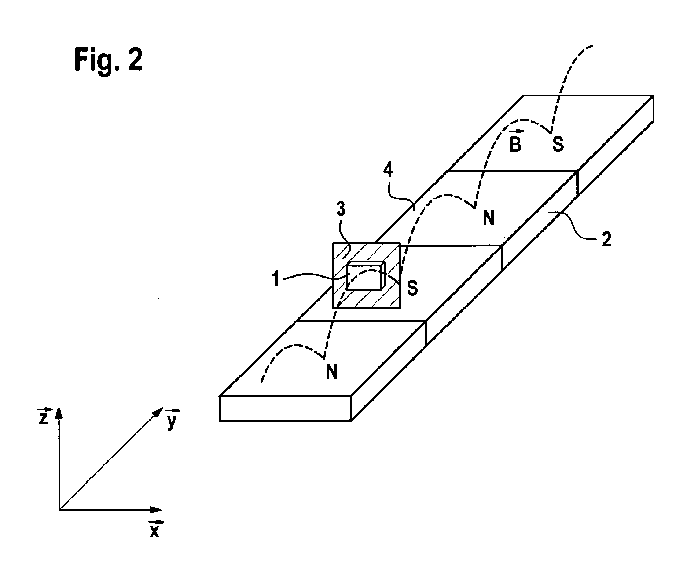

Fig. 2 zeigt eine beispielhafte Sensoranordnung bei welcher Sensor 1 bezüglich seiner ersten sensitiven Hauptebene 3 senkrecht zur Encoderspurfläche 4 des Encoders 2 ausgerichtet ist. Ein nicht dargestelltes erstes Magnetfeldsensorelement, welches als AMR-Sensorelement ausgebildet und bezüglich seiner sensitiven Strukturen parallel zur sensitiven Hauptebene angeordnet ist, erfasst das Magnetfeld B beispielhaft bezüglich seiner Komponenten in Z-Richtung. Das nicht dargestellte zweite Magnetfeldsensorelement, welches als Hall-Element ausgebildet ist und ebenfalls bezüglich seiner sensitiven Strukturen parallel zur sensitiven Hauptebene 3 angeordnet ist und somit parallel zum AMR-Sensorelement, erfasst y-Komponenten des Magnetfelds B.

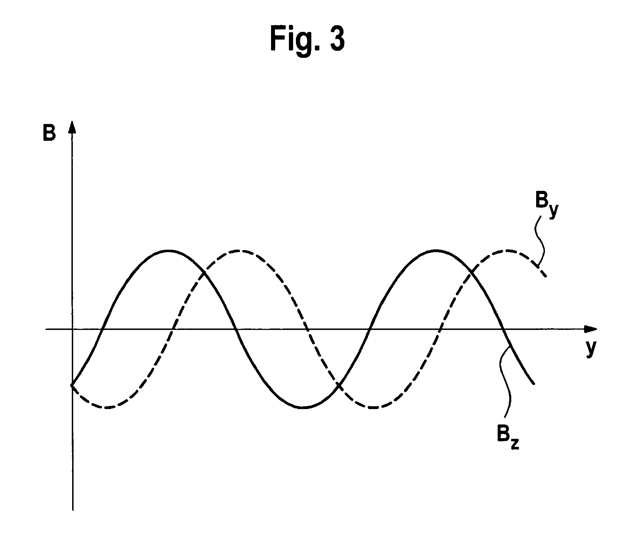

In Fig. 3 sind beispielhafte Elementausgangssignale der Magnetfeldsensorelemente der Sensoranordnung aus Fig. 1 dargestellt. Dabei ist die erfasste magnetische Flussdichte B der magnetischen Feldkomponenten in y-Richtung gestrichelt dargestellt.

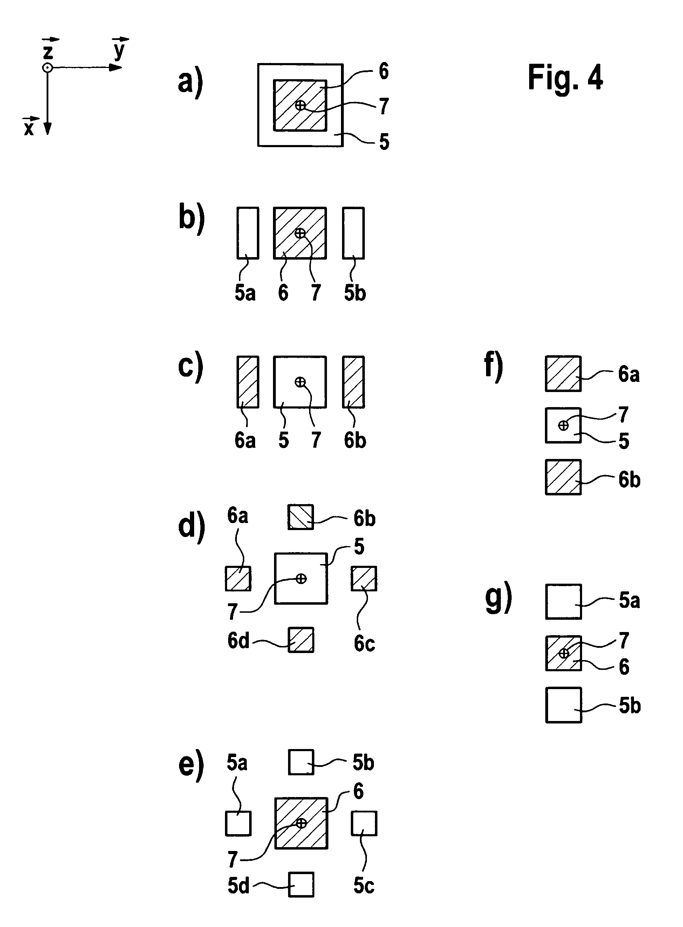

Fig. 4 zeigt in den Darstellungen a) bis g) verschiedene, beispielhafte Anordnungen des zumindest ersten Magnetfeldsensorelements 5 oder einer Gruppe von Magnetfeldsensorelementen 5a, 5b, 5c ,5d mit der ersten Haupterfassungsrichtung relativ zum zweiten Magnetfeldsensorelement 6 oder einer Gruppe von Magnetfeldsensorelementen 6a, 6b, 6c, 6d mit der zweiten Haupterfassungsrichtung. Die Magnetfeldsensorelemente mit der ersten Haupterfassungsrichtung sind beispielgemäß als AMR-Sensorelemente ausgebildet und die Magnetfeldsensorelemente mit der zweiten Haupterfassungsrichtung als Hall-Elemente, welche schraffiert gekennzeichnet sind. Beispielgemäß sind sämtliche Magnetfeldsensorelemente bezüglich ihrer sensitiven Strukturen parallel bzw. in der ersten sensitiven Hauptebene des Sensors angeordnet bzw. liegen flächig zur ersten sensitiven Hauptebene. Das eine oder die mehreren AMR-Sensorelemente 5, 5a, 5b, 5c, 5d sind dabei jeweils im Wesentlichen konzentrisch zu dem einen oder den mehreren Hall-Elementen 6, 6a, 6b, 6c, 6d angeordnet und weisen einen gemeinsamen definierten Erfassungspunkt 7 auf. Die AMR-Sensorelemente 5, 5a, 5b, 5c, 5d weisen die erste Haupterfassungsrichtung in y-Richtung auf und die Hall-Elemente 6, 6a, 6b, 6c, 6d die zweite Haupterfassungsrichtung in z-Richtung, jeweils gemäß einer in Fig. 1 dargestellten relativen Ausrichtung zwischen Sensor und Encoder. Bezüglich einer in Fig. 2 dargestellten relativen Ausrichtung zwischen Sensor und Encoder weisen die AMR-Sensorelemente die erste Haupterfassungsrichtung in z-Richtung auf und die Hall-Elemente die zweite Haupterfassungsrichtung in y-Richtung.

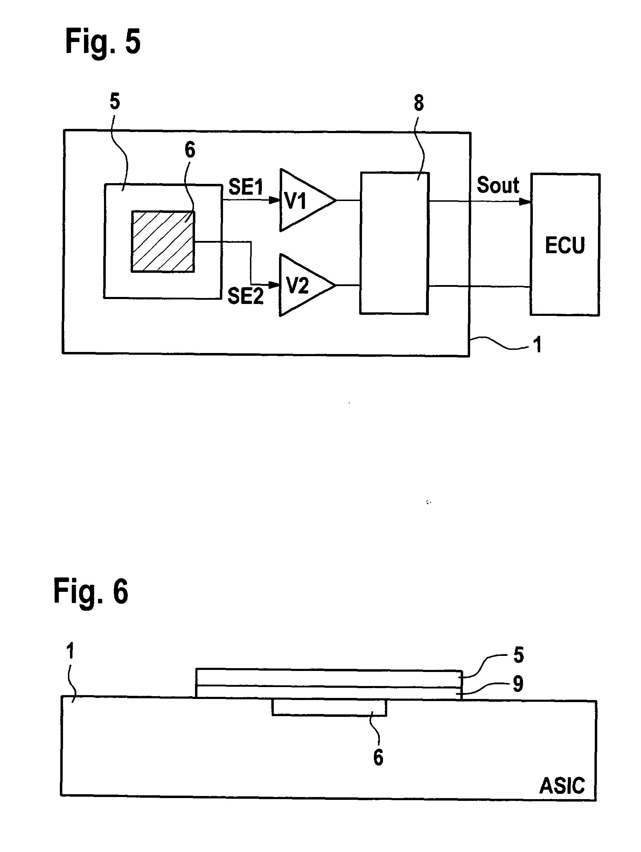

Fig. 5 veranschaulicht beispielhaft die Anbindung eines Sensors 1 an eine elektronische Kontrolleinheit ECU mittels einer Zwei-Draht-Schnittstelle. Sensor 1 weist dabei ein AMR-Sensorelement 5 mit Elementausgangssignal SE1 und ein Hall-Element 6 mit Elementausgangssignal SE2 auf. Die Elementausgangssignale SE1, SE2 werden jeweils in einer Signalaufbereitungsstufe V1, V2 vorverstärkt und einer Signalverarbeitungsschaltung 8 zugeführt, welche ein digitales Sensorausgangssignal Sout erzeugt, das an die ECU übertragen wird. Dieses Sensorausgangssignal enthält beispielhaft Positionsinformationen, Geschwindigkeitsinformationen sowie verschiedene Zusatzinformationen.

In Fig. 6 ist ein beispielhafter, integrierter, als Chip ausgebildeter Sensor 1 abgebildet. Dieser umfasst einen ASIC, welcher eine Signalverarbeitungsschaltung aufweist. Ein Hall-Element 6, als zweites Magnetfeldsensorelement, ist in den ASIC integriert. Der ASIC weist auf seiner oberen Außenfläche eine Isolierschicht 9 auf, auf welcher ein magnetoresistives Sensorelement 5, als erstes Magnetfeldsensorelement, in Dünnschichttechnologie angeordnet ist.

## Patentansprüche

1. Positions- und/oder Geschwindigkeitssensoranordnung, umfassend einen Sensor (1) mit wenigstens einer ersten sensitiven Hauptebene (3) und einen Encoder (2) mit zumindest einer Encoderspurfläche (4), wobei der Sensor (1) ein von dem Encoder (2) erzeugtes und/oder moduliertes Magnetfeld (B̅) erfassen kann und wobei der Sensor zumindest ein erstes (5) und ein zweites (6) Magnetfeldsensorelement aufweist, wobei das erste Magnetfeldsensorelement (5) mindestens eine erste Haupterfassungsrichtung (y̅)̅ aufweist und das zweite Magnetfeldsensorelement (6) eine wenigstens zweite, zur ersten Haupterfassungsrichtung verschiedene, Haupterfassungsrichtung (z) aufweist, wobei
das erste (5) und das zweite (6) Magnetfeldsensorelement so angeordnet sind, dass mindestens ein Elementausgangssignal (SE1) des ersten Magnetfeldsensorelements (5) zu wenigstens einem Elementausgangssignal (SE2) des zweiten Magnetfeldsensorelements (6) einen Phasenverschiebungsbetrag zwischen 75° und 105° aufweist, **dadurch gekennzeichnet, dass**
das erste Magnetfeldsensorelement (5) mit der ersten Haupterfassungsrichtung als magnetoresistives Sensorelement ausgebildet ist und das zweite Magnetfeldsensorelement (6) mit der zweiten Haupterfassungsrichtung als Hall-Element ausgebildet ist, wobei
zumindest das erste (5) und das zweite (6) Magnetfeldsensorelement so angeordnet sind, dass sie das Magnetfeld (B̅) bezüglich der ersten sensitiven Hauptebene (3) des Sensors (1) in einem definierten, gemeinsamen Erfassungspunkt (7) im Wesentlichen gemeinsam erfassen.

2. Sensoranordnung nach Anspruch 1, **dadurch gekennzeichnet, dass** dieser Phasenverschiebungsbetrag im Wesentlichen 90° beträgt.

3. Sensoranordnung nach Anspruch 1 oder 2, **dadurch gekennzeichnet, dass** der Sensor (1) bezüglich seiner ersten sensitiven Hauptebene (3) im Wesentlichen parallel zur Encoderspurfläche (4) des Encoders (2) ausgerichtet ist.

4. Sensoranordnung nach mindestens einem der Ansprüche 1 bis 3, **dadurch gekennzeichnet, dass** das erste (5) und das zweite (6) Magnetfeldsensorelement jeweils eine oder mehrere sensitive Strukturen aufweisen, die jeweils im Wesentlichen in einer Strukturebene angeordnet sind, wobei das erste und das zweite Magnetfeldsensorelement bezüglich ihrer jeweiligen Strukturebene im Wesentlichen zueinander parallel oder in einer gemeinsamen Ebene angeordnet sind.

5. Sensoranordnung nach mindestens einem der Ansprüche 1 bis 4, **dadurch gekennzeichnet, dass** die erste Haupterfassungsrichtung (y̅) gegenüber der zweiten Haupterfassungsrichtung (z̅) um im Wesentlichen 90° gedreht ausgeprägt ist.

6. Sensoranordnung nach mindestens einem der Ansprüche 1 bis 5, **dadurch gekennzeichnet, dass** ein (5) oder mehrere Magnetfeldsensorelemente (5a, 5b, 5c, 5d) mit der ersten Haupterfassungsrichtung (y̅, z̅) gemeinsam relativ gegenüber einem (6) oder mehreren Magnetfeldsensorelementen (6a, 6b, 6c, 6d) mit der zweiten Haupterfassungsrichtung (z̅, y̅) bezüglich der sensitiven Hauptebene (3) und des definierten Erfassungspunktes (7) im Wesentlichen konzentrisch angeordnet sind.

7. Sensoranordnung nach mindestens einem der Ansprüche 1 bis 6, **dadurch gekennzeichnet, dass** der Sensor (1) eine Signalverarbeitungsschaltung (8) aufweist, die so ausgelegt ist, dass sie zumindest aus den Elementausgangssignalen (SE1, SE2) des ersten (5) und des zweiten (6) Magnetfeldsensorelements ein, insbesondere digitales, Sensorausgangssignal (Sout) erzeugt, welches zumindest eine der folgenden Informationen beinhaltet:
die Relativ- und/oder Absolutposition zwischen Encoder und Sensor und/oder die Relativgeschwindigkeit zwischen Encoder und Sensor und/oder die relative Bewegungsrichtung zwischen Encoder und Sensor und/oder die magnetische Feldstärke des vom Sensor erfassten Magnetfeldes und/oder der Abstand zwischen Encoder und Sensor und/oder mindestens eine Information über die Plausibilität des Sensorausgangssignals.

8. Sensoranordnung nach mindestens einem der Ansprüche 1 bis 7, **dadurch gekennzeichnet, dass** der Sensor (1) einen Chip umfasst, welcher zumindest das erste (5) und das zweite (6) Magnetfeldsensorelement sowie insbesondere die Signalverarbeitungsschaltung (ASIC) aufweist.

9. Verfahren zur Positions- und/oder Geschwindigkeitsmessung mit einer Sensoranordnung, insbesondere gemäß mindestens einem der Ansprüche 1 bis 8, bei welchem mittels eines Sensors (1), der zumindest eine erste sensitive Hauptebene (3) und zumindest ein erstes (5) und ein zweites (6) Magnetfeldsensorelement aufweist, ein durch einen Encoder (2) erzeugtes und/oder moduliertes Magnetfeld (B̅) erfasst wird, wobei das erste Magnetfeldsensorelement (5) wenigstens eine erste Haupterfassungsrichtung (y̅) aufweist und das zweite (6) Magnetfeldsensorelement zumindest eine zweite, zur ersten Haupterfassungsrichtung verschiedene, Haupterfassungsrichtung (y̅z̅) aufweist, wobei
mindestens ein Elementausgangssignal (SE1) des ersten Magnetfeldsensorelements (5) und wenigstens ein Elementsausgangssignal (SE2) des zweiten Magnetfeldsensorelements (6) im Zuge der Erfassung des Magnetfeldes (B̅) erzeugt werden, wobei diese beiden Elementausgangssignale (SE1, SE2) relativ zueinander einen Phasenverschiebungsbetrag zwischen 75° und 105° aufweisen, **dadurch gekennzeichnet, dass**
das erste Magnetfeldsensorelement (5) mit der ersten Haupterfassungsrichtung als magnetoresistives Sensorelement ausgebildet ist und das zweite Magnetfeldsensorelement (6) mit der zweiten Haupterfassungsrichtung als Hall-Element ausgebildet ist, wobei
zumindest das erste (5) und das zweite (6) Magnetfeldsensorelement so angeordnet sind, dass sie das Magnetfeld (B̅) bezüglich der ersten sensitiven Hauptebene (3) des Sensors (1) in einem definierten, gemeinsamen Erfassungspunkt (7) im Wesentlichen gemeinsam erfassen.

10. Verfahren nach Anspruch 9, **dadurch gekennzeichnet, dass** in einer Signalverarbeitungsschaltung (8) aus den Elementausgangssignalen (SE1, SE2) zumindest eine der folgenden Information direkt oder indirekt gewonnen wird: die Relativ- und/oder Absolutposition zwischen Encoder und Sensor und/oder die Relativgeschwindigkeit zwischen Encoder und Sensor und/oder die relative Bewegungsrichtung zwischen Encoder und Sensor und/oder die magnetische Feldstärke des vom Sensor erfassten Magnetfeldes und/oder der Abstand zwischen Encoder und Sensor und/oder mindestens eine Information über die Plausibilität des Sensorausgangssignals.

11. Verwendung der Sensoranordnung gemäß mindestens einem der Ansprüche 1 bis 8 in Kraftfahrzeugen, insbesondere als Drehzahlsensoranordnung.

## Claims

1. Position- and/or speed-sensor arrangement comprising a sensor (1) with at least a first sensitive main plane (3) and an encoder (2) with at least one encoder track face (4), wherein the sensor (1) can sense a magnetic field (B̅) which is generated and/or modulated by the encoder (2), and wherein the sensor has at least a first magnetic field sensor element (5) and a second magnetic field sensor element (6), wherein the first magnetic field sensor element (5) has at least a first main sensing direction (y̅) and the second magnetic field sensor element (6) has an at least second main sensing direction (z̅) which is different from the first main sensing direction,
wherein
the first magnetic field sensor element (5) and the second magnetic field sensor element (6) are arranged in such a way that at least an element output signal (SE1) of the first magnetic field sensor element (5) has a phase shift absolute value between 75° and 105° with respect to at least one element output signal (SE2) of the second magnetic field sensor element (6), **characterized in that** the first magnetic field sensor element (5) with the first main sensing direction is embodied as a magnetoresistive sensor element, and the second magnetic field sensor element (6) with the second main sensing direction is embodied as a Hall element, wherein
at least the first magnetic field sensor element (5) and the second magnetic field sensor element (6) are arranged in such a way that they essentially jointly sense the magnetic field (B̅) with respect to the first sensitive main plane (3) of the sensor (1) at a defined common sensing point (7).

2. Sensor arrangement according to Claim 1, **characterized in that** this phase shift absolute value is essentially 90°.

3. Sensor arrangement according to Claim 1 or 2, **characterized in that** the sensor (1) is oriented, with respect to its first sensitive main plane (3), essentially parallel to the encoder track face (4) of the encoder (2).

4. Sensor arrangement according to at least one of Claims 1 to 3, **characterized in that** the first magnetic field sensor element (5) and the second magnetic field sensor element (6) each have one or more sensitive structures which are each arranged essentially in a structural plane, wherein the first and second magnetic field sensor elements are arranged, with respect to their particular structural plane, essentially parallel to one another or in a common plane.

5. Sensor arrangement according to at least one of Claims 1 to 4, **characterized in that** the first main sensing direction (y̅) is embodied rotated through essentially 90° with respect to the second main sensing direction (z̅).

6. Sensor arrangement according to at least one of Claims 1 to 5, **characterized in that** one magnetic field sensor element (5) or a plurality of magnetic field sensor elements (5a, 5b, 5c, 5d) with the first main sensing direction (y̅, z̅) together are arranged substantially concentrically in relation to one magnetic field sensor element (6) or a plurality of magnetic field sensor elements (6a, 6b, 6c, 6d) with the second main sensing direction (z̅, y̅), essentially concentrically with respect to the sensitive main plane (3) and the defined sensing point (7).

7. Sensor arrangement according to at least one of Claims 1 to 6, **characterized in that** the sensor (1) has a signal processing circuit (8) which is configured in such a way that it generates, at least from the element output signals (SE1, SE2) of the first magnetic field sensor element (5) and of the second magnetic field sensor element (6), an, in particular, digital sensor output signal (Sout) which contains at least one of the following information items:
the relative position and/or absolute position between the encoder and sensor and/or the relative speed between the encoder and sensor and/or the relative direction of movement between the encoder and sensor and/or the magnetic field strength of the magnetic field which is sensed by the sensor and/or the distance between the encoder and the sensor and/or at least an information item relating to the plausibility of the sensor output signal.

8. Sensor arrangement according to at least one of Claims 1 to 7, **characterized in that** the sensor (1) comprises a chip which has at least the first magnetic field sensor element (5) and the second magnetic field sensor element (6) as well as, in particular, the signal processing circuit (ASIC).

9. Method for measuring positions and/or speeds with a sensor arrangement, in particular according to at least one of Claims 1 to 8, in which, by means of a sensor (1) which has at least a first sensitive main plane (3) and at least a first magnetic field sensor element (5) and a second magnetic field sensor element (6), a magnetic field (B̅) which is generated and/or modulated by means of an encoder (2) is sensed, wherein the first magnetic field sensor element (5) has at least a first main sensing direction (y̅) and the second magnetic field sensor element (6) has at least a second main sensing direction (z̅) which is different from the first main sensing direction,
wherein
at least one element output signal (SE1) of the first magnetic field sensor element (5) and at least one element output signal (SE2) of the second magnetic field sensor element (6) are generated in the course of the sensing of the magnetic field (B̅) wherein these two element output signals (SE1, SE2) have a phase shift absolute value between 75° and 105° in relation to one another, **characterized in that** the first magnetic field sensor element (5) with the first main sensing direction is embodied as a magnetoresistive sensor element, and the second magnetic field sensor element (6) with the second main sensing direction is embodied as a Hall element, wherein
at least the first magnetic field sensor element (5) and the second magnetic field sensor element (6) are arranged in such a way that they essentially jointly sense the magnetic field (B̅) with respect to the first sensitive main plane (3) of the sensor (1) at a defined common sensing point (7).

10. Method according to Claim 9, **characterized in that** at least one of the following information items is acquired directly or indirectly from the element output signals (SE1, SE2) in a signal processing circuit (8): the relative position and/or absolute position between the encoder and sensor and/or the relative speed between the encoder and sensor and/or the relative direction of movement between the encoder and sensor and/or the magnetic field strength of the magnetic field which is sensed by the sensor and/or the distance between the encoder and the sensor and/or at least one information item relating to the plausibility of the sensor output signal.

11. Use of the sensor arrangement according to at least one of Claims 1 to 8 in motor vehicles, in particular as a rotational speed sensor arrangement.

## Revendications

1. Arrangement de détection de position et/ou de vitesse, comprenant un capteur (1) doté d'au moins un premier plan principal sensible (3) et un codeur (2) doté d'au moins une surface de trace de codeur (4), le capteur (1) pouvant détecter un champ magnétique (B̅) généré et/ou modulé par le codeur (2) et le capteur présentant au moins un premier (5) et un deuxième (6) élément de détection de champ magnétique, le premier élément de détection de champ magnétique (5) présentant au moins une première direction de détection principale (Y) et le deuxième élément de détection de champ magnétique (6) présentant une au moins deuxième direction de détection principale (z̅), différente de la première direction de détection principale, le premier (5) et le deuxième (6) élément de détection de champ magnétique étant disposés de telle sorte qu'au moins un signal de sortie d'élément (SE1) du premier élément de détection de champ magnétique (5) présente, en référence à au moins un signal de sortie d'élément (SE2) du deuxième élément de détection de champ magnétique (6), un taux de déphasage compris entre 75° et 105°, **caractérisé en ce que** le premier élément de détection de champ magnétique (5) avec la première direction de détection principale est réalisé sous la forme d'un élément de détection magnétorésistif et le deuxième élément de détection de champ magnétique (6) avec la deuxième direction de détection principale est réalisé sous la forme d'un élément à effet Hall, au moins le premier (5) et le deuxième (6) élément de détection de champ magnétique étant disposés de telle sorte qu'ils détectent pour l'essentiel ensemble le champ magnétique (B̅) par rapport au premier plan principal sensible (3) du capteur (1) en un point de détection (7) défini commun.

2. Arrangement de détection selon la revendication 1, **caractérisé en ce que** ce taux de déphasage est pour l'essentiel égal à 90°.

3. Arrangement de détection selon la revendication 1 ou 2, **caractérisé en ce que** le capteur (1) est orienté pour l'essentiel parallèlement à la surface de trace de codeur (4) du codeur (2) en référence à son premier plan principal sensible (3).

4. Arrangement de détection selon au moins l'une des revendications 1 à 3, **caractérisé en ce que** le premier (5) et le deuxième (6) élément de détection de champ magnétique présentent respectivement une ou plusieurs structures sensibles qui sont respectivement disposées pour l'essentiel dans un plan de structure, le premier et le deuxième élément de détection de champ magnétique étant disposés pour l'essentiel parallèlement l'un à l'autre en référence à leur plan de structure respectif ou dans un plan commun.

5. Arrangement de détection selon au moins l'une des revendications 1 à 4, **caractérisé en ce que** la première direction de détection principale (y̅) est marquée par une rotation d'essentiellement 90° par rapport à la deuxième direction de détection principale (z̅).

6. Arrangement de détection selon au moins l'une des revendications 1 à 5, **caractérisé en ce qu'**un (5) ou plusieurs (5a, 5b, 5c, 5d) éléments de détection de champ magnétique présentant la première direction de détection principale (y̅, z̅) sont disposés ensemble de manière essentiellement concentrique par rapport à un (6) ou plusieurs (6a, 6b, 6c, 6d) éléments de détection de champ magnétique présentant la deuxième direction de détection principale (z̅, y̅) en référence au plan principal sensible (3) et au point de détection (7) défini.

7. Arrangement de détection selon au moins l'une des revendications 1 à 6, **caractérisé en ce que** le capteur (1) présente un circuit de traitement de signal (8) qui est conçu de telle sorte qu'il génère au moins à partir des signaux de sortie d'élément (SE1, SE2) du premier (5) et du deuxième (6) élément de détection de champ magnétique, un signal de sortie de capteur (Sout), notamment numérique, qui contient au moins l'une des informations suivantes :
la position relative et/ou absolue entre le codeur et le capteur et/ou la vitesse relative entre le codeur et le capteur et/ou le sens de déplacement relatif entre le codeur et le capteur et/ou l'intensité de champ magnétique du champ magnétique détecté par le capteur et/ou l'écart entre le codeur et le capteur et/ou au moins une information sur la plausibilité du signal de sortie de capteur.

8. Arrangement de détection selon au moins l'une des revendications 1 à 7, **caractérisé en ce que** le capteur (1) comprend une puce qui présente au moins le premier (5) et le deuxième (6) élément de détection de champ magnétique ainsi qu'en particulier le circuit de traitement de signal (ASIC).

9. Procédé de mesure de la position et/ou de la vitesse avec un arrangement de détection, notamment selon au moins l'une des revendications 1 à 8, selon lequel un champ magnétique (B̅) généré et/ou modulé par un codeur (2) est détecté au moyen d'un capteur (1), lequel présente au moins un premier plan principal sensible (3) et au moins un premier (5) et un deuxième (6) élément de détection de champ magnétique, le premier élément de détection de champ magnétique (5) présentant au moins une première direction de détection principale (y̅) et le deuxième élément de détection de champ magnétique (6) présentant au moins une deuxième direction de détection principale (z̅), différente de la première direction de détection principale, au moins un signal de sortie d'élément (SE1) du premier élément de détection de champ magnétique (5) et au moins un signal de sortie d'élément (SE2) du deuxième élément de détection de champ magnétique (6) étant générés dans le cadre de la détection du champ magnétique (B̅), ces deux signaux de sortie d'élément (SE1, SE2) présentant l'un par rapport à l'autre un taux de déphasage compris entre 75° et 105°, **caractérisé en ce que** le premier élément de détection de champ magnétique (5) avec la première direction de détection principale est réalisé sous la forme d'un élément de détection magnétorésistif et le deuxième élément de détection de champ magnétique (6) avec la deuxième direction de détection principale est réalisé sous la forme d'un élément à effet Hall, au moins le premier (5) et le deuxième (6) élément de détection de champ magnétique étant disposés de telle sorte qu'ils détectent pour l'essentiel ensemble le champ magnétique (B̅) par rapport au premier plan principal sensible (3) du capteur (1) en un point de détection (7) défini commun.

10. Procédé selon la revendication 9, **caractérisé en ce qu'**au moins l'une des informations suivantes est obtenue directement ou indirectement dans un circuit de traitement de signal (8) à partir des signaux de sortie d'élément (SE1, SE2) :
la position relative et/ou absolue entre le codeur et le capteur et/ou la vitesse relative entre le codeur et le capteur et/ou le sens de déplacement relatif entre le codeur et le capteur et/ou l'intensité de champ magnétique du champ magnétique détecté par le capteur et/ou l'écart entre le codeur et le capteur et/ou au moins une information sur la plausibilité du signal de sortie de capteur.

11. Utilisation de l'arrangement de détection selon au moins l'une des revendications 1 à 8 dans des véhicules automobiles, notamment en tant qu'arrangement de détection de la vitesse de rotation.
